# FASCICULE DE BREVET EUROPEEN

(11) **EP 3 109 900 B1**
(45) Date de publication et mention de la délivrance du brevet: **11.10.2017**
(21) Numéro de dépôt: 16174695.3
(22) Date de dépôt: 16.06.2016
(51) Int. Cl.: H01L 27/144, H01L 27/146

(54) **PROCEDE DE FABRICATION D'UNE PLURALITE DE DIPOLES EN FORME D'ILOTS AYANT DES ELECTRODES AUTO-ALIGNEES**
HERSTELLUNGSVERFAHREN EINER VIELZAHL VON DIPOLEN IN FORM VON INSELN, DIE SELBSTAUSRICHTENDE ELEKTRODEN UMFASSEN
METHOD FOR MANUFACTURING A PLURALITY OF DIPOLES IN THE FORM OF ISLANDS WITH SELF-ALIGNED ELECTRODES

(30) Priorité: 24.06.2015 FR 1555785
(43) Date de publication de la demande: 28.12.2016
(73) Titulaire: COMMISSARIAT À L'ÉNERGIE ATOMIQUE ET AUX ÉNERGIES ALTERNATIVES, 75015 Paris (FR)
(72) Inventeur: MARION, François, 38950 SAINT MARTIN LE VINOUX (FR)
(74) Mandataire: Cabinet Laurent & Charras

(56) Documents cités:
- EP-A1- 2 390 933
- FR-A1- 2 184 995
- US-A1- 2015 115 290

## Description

### DOMAINE DE L'INVENTION

L'invention a trait au domaine de la fabrication de composants électroniques, et plus particulièrement à la fabrication de composants électroniques comportant sur une même face une densité importante de dipôles.

L'invention s'applique notamment aux dispositifs comportant deux composants électriques interconnectés face contre face avec de très petits pas d'interconnexion, au moyen d'une technique d'hybridation de type « *flip-chip* », ou « puce retournée ». L'invention trouve ainsi particulièrement application dans les assemblages dits « puce sur puce », « puce sur wafer » et « wafer sur wafer ». Par exemple, l'invention s'applique aux matrices d'éclairage et aux imageurs hybridés de très grandes dimensions et à très petits pas.

### ETAT DE LA TECHNIQUE

L'augmentation de la densité de composants électroniques (diodes, transistors, résistances, capacités...), c'est-à-dire le nombre de composants par unité de surface, dans les circuits électroniques se heurte souvent à la précision limitée des procédés de fabrication, notamment la photolithographie. Cette problématique est d'autant plus présente pour un composant électrique qui comprend plusieurs parties fabriquées successivement et nécessitant d'être positionnées avec précision les unes par rapport aux autres, par exemple afin d'éviter des court-circuits. Par ailleurs, la difficulté est encore plus grande lorsque plusieurs niveaux de connexion sont présents dans un composant électronique, comme cela est notamment le cas d'un dipôle de type « ilot », par exemple une photodiode (communément appelée photodiode « mésa »), dont le fonctionnement nécessite d'appliquer une différence de potentiels entre le sommet et le pied de l'ilot.

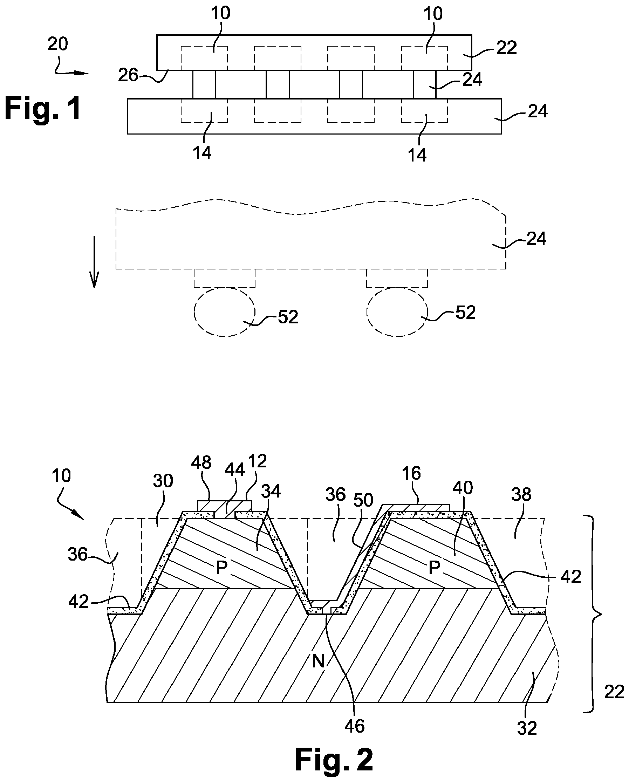

Ces problématiques sont illustrées aux figures 1 et 2 dans le cas particuliers d'un afficheur et un détecteur matriciel à base de photodiodes.

En se référant aux figures 1 et 2, il est d'usage, pour réaliser un afficheur (respectivement un détecteur) matriciel **20,** de former une matrice de photodiodes **10** dans un premier composant électronique **22** d'émission (respectivement de détection) et de former les circuits d'injection de courant **14** (respectivement de collecte de courant **18**) dans un second composant électronique 24 de commande (respectivement de lecture). Les deux composants 22, 24 sont fabriqués indépendamment l'un de l'autre, puis sont ensuite hybridés l'un avec l'autre au moyen d'une technique dite « *flip chip* ». L'hybridation permet de connecter électriquement les électrodes 12 des photodiodes 10 avec leur circuits d'injection 14, (respectivement de collecte 18) respectifs, au moyen d'interconnexions métalliques 24, qui sont usuellement également prévues pour solidariser les composants 22, 24. Les électrodes 16 des photodiodes 10 sont quant à elles, par exemple connectées à un même potentiel électrique au moyen de diverses techniques. Selon une première technique, le premier composant **22** comprend, en son sein ou sur sa face **26** destinée à être connectée avec le composant **24,** une couche conductrice ou fortement dopée en contact avec toutes les électrodes **16** des photodiodes **10.** Cette technique est cependant rédhibitoire pour les matrices de photodiodes de grandes dimensions en raison de la résistance électrique en série qu'implique ladite couche.

De fait, les électrodes **12, 16** des photodiodes **10** sont fabriquées de manière à être accessibles depuis la face **26** du composant **22** pour leur connexion électrique. Parallèlement, une photodiode consistant essentiellement en des volumes de matériaux différents empilés et/ou alignés les uns avec les autres, la fabrication des photodiodes **10** utilise avantageusement des techniques de gravure pour aligner automatiquement un nombre maximum de composants des photodiodes. Cette fabrication est illustrée à la figure 2 qui est une vue schématique en coupe d'une photodiode **10** de type mesa dans une forme simplifiée de jonction PN.

En se référant plus particulièrement à la figure 2, pour fabriquer la photodiode **10,** un volume de matériau semi-conducteur de dopage par exemple P **30** est réalisé sur une couche **32** de matériau semi-conducteur de dopage par exemple N **32** de manière à former une jonction PN. Un îlot de matériau semi-conducteur P **34** est ensuite individualisé en déposant par photolithographie un masque de gravure sur le volume P **30,** par exemple un masque de SiO₂ déposé par une technique de dépôt en phase vapeur assistée par plasma (ou « PECVD »), puis en appliquant une gravure de manière à réaliser une tranchée **36** autour du volume **34** jusqu'à atteindre le matériau semi-conducteur N (voir plus haut) **32.** Par exemple, la gravure est une gravure ionique couplée à un plasma induit (ou gravure « RIE-ICP » pour « *reactive-ion etching inductively coupled plasma* »). La gravure est également appliquée de manière à réaliser une tranchée **38** de même hauteur de manière à isoler un ilot P **40** à proximité de l'ilot P **34.** Une couche de passivation **42,** par exemple en SiN, est ensuite déposée sur toute la surface des ilots P **34, 40** et la surface des tranchées **36, 38,** par exemple au moyen d'un dépôt PECVD. La couche de passivation **42,** bien qu'optionnelle, est considérée comme quasi-obligatoire. Non seulement, elle corrige les défauts de surface de l'ilot P **34,** défauts qui sont une cause importante de recombinaisons non souhaitées des porteurs de charge, mais en outre la couche **42** permet d'isoler électriquement différents éléments de la photodiode **10,** et permet ainsi de se prémunir contre d'éventuels court-circuits lors du dépôt ultérieur du métal formant les électrodes de la photodiode **10.** Le procédé de fabrication de la photodiode **10** se poursuit par la réalisation d'ouvertures **44, 46** dans la couche de passivation **42,** à la fois sur le sommet de l'ilot P **34** et dans le fond de la tranchée **36** individualisant celui-ci, par exemple au moyen d'une gravure RIE. Une couche de métal est alors déposée pleine plaque puis est gravée pour faire apparaître une première métallisation **48** au sommet de l'ilot P **34** formant une première électrode **12** de la photodiode **10** ainsi qu'une deuxième métallisation **50,** isolée de la métallisation **48,** réalisée dans le fond de la tranchée **36** et formant une deuxième électrode **16** de la photodiode **10.** Cette structure permet ainsi une reprise de contact, par exemple par des billes de soudure **52** du composant **24,** de l'anode **12** et de la cathode **16** sensiblement au même niveau, ce qui facilite l'hybridation avec le composant **24.** Cette structure est cependant très consommatrice de surface et le pas de la matrice de photodiodes est sensiblement doublé, ce qui limite donc la densité d'intégration des photodiodes.

Afin d'augmenter la densité d'intégration, il serait ainsi possible de ne pas prévoir une reprise de contact de la cathode au même niveau que l'anode. L'ilot P **40** est donc supprimé et la reprise de contact de la cathode **16** est réalisée directement dans le fond de la tranchée **36.** Ce type de structure est classique. Toutefois, comme le décrit le document « A Novel Blu-free Full-Color LED projecter Using LED on Silicon Micro-Displays » de Z.J. Liu et al., IEEE Photonics Technology Letters, vol. 25, N°23, Decembre 2013, cela suppose de prévoir des connexions **52** de différentes hauteurs sur le composant **24,** ce qui est particulièrement complexe lorsqu'une hybridation de qualité est recherchée. En outre, lorsque la reprise de contact de la cathode est réalisée directement dans le fond de la tranchée **36,** l'accès à celle-ci devient très difficile si le diamètre de la tranchée est faible. Au mieux cela demande donc des outillages d'alignement très précis, et donc très couteux. Au pire, il est impossible de descendre en deçà d'un pas de matrice donné.

De même, il peut être également envisagé de réduire la largeur de la tranchée **36** pour réduire le pas de la matrice de photodiodes. Toutefois, il se pose alors un problème dans la réalisation de l'ouverture **46** donnant accès à la couche N pour la conception de la cathode. En outre, en réduisant la largeur de la tranchée **36,** des précautions particulières doivent être prises pour que la métallisation **50** ne chevauche pas la métallisation **44.** Il est donc souhaitable d'utiliser les techniques de fabrication bien au-delà de leur précision pour garantir le positionnement souhaité des éléments de la photodiode les uns par rapport aux autres. On note ainsi que dans l'état de la technique, tel que par exemple décrit dans le document « 360 PPI Flip-Chip Mounted Active Matrix Adressable Light Emitting Diode on Silicon (LEDoS) Micro-Display », de Z.J. Liu, Journal of Display Technology, vol.9, N°8, août 2013, ou encore décrit dans le document ci-dessous, le pas de la matrice est de l'ordre de la dizaine de micromètres.
Bien entendu, ce qui vient d'être exposé, bien que décrit en relation avec des diodes, s'applique à tout type d'élément électronique, notamment de dipôles, dès lors qu'il est souhaité connecter deux électrodes de cet élément associées respectivement à deux niveaux différents. Par exemple, la problématique exposée ci-dessus s'applique à une matrice de photoconducteurs, par exemple formés d'un empilement N/N+ ou P/P+, à une matrice de capacités, une matrice de bolomètres, une matrice de diode Zener, etc. EP 2 390 933 divulgue un procédé de fabrication d'un composant électronique semiconducteur.

### EXPOSE DE L'INVENTION

Le but de la présente invention est de proposer un procédé de fabrication d'une matrice de dipôles en ilots nécessitant chacun deux connections à des niveaux respectifs différents, permettant une connexion aisée des dipôles, y compris pour des pas de matrice jugés petits au regard de la précision des techniques de fabrication.

A cet effet, l'invention a pour objet un procédé de fabrication d'un composant électronique comportant une pluralité de dipôles chacun comportant un ilot solidaire d'un socle, une première électrode disposée au sommet de l'ilot et une seconde électrode disposée sur le socle, le procédé comportant :
- la réalisation, sur le socle, d'une épaisseur de matériau constitutif des ilots, ladite épaisseur étant apte à être gravée à l'aide d'une gravure isotrope prédéterminée;
- suivie de la réalisation, sur l'épaisseur de matériau constitutif des ilots, de motifs pleins en matériau électriquement conducteur et inerte à la gravure isotrope;
- suivie de l'application d'une gravure l'épaisseur de matériau constitutif des ilots jusqu'au socle au moins entre lesdits motifs pleins de manière à former des ilots surmontés desdits motifs pleins, ladite gravure comportant au moins une phase pendant laquelle la gravure isotrope prédéterminée est appliquée de manière à ce que les motifs pleins surplombent totalement les ilots; et
- suivie du dépôt de matériau électriquement conducteur sur et entre les ilots de manière à former les premières et les secondes électrodes des dipôles.

Par « matériau inerte à la gravure », on entend ici que le matériau n'est sensiblement pas gravé par la gravure pendant la réalisation des ilots. Notamment, la vitesse V de gravure du matériau est inférieure ou égale à 1/10^{e} de la vitesse de gravure du matériau constitutif des ilots auquel la gravure est destinée, et de préférence inférieure ou égale à 1/100^{e}, notamment inférieure ou égale à 1/1000^{e}.

Par « gravure anisotrope d'un matériau», on entend une gravure directive destinée à graver le matériau dans une direction particulière, notamment une gravure dont la vitesse de gravure, dans une direction normale à cette direction particulière, est inférieure ou égale à 10%, et de préférence inférieure ou égale à 1%, de la vitesse de gravure du matériau dans la direction particulière.

Par « gravure isotrope d'un matériau », on entend une gravure dont la vitesse de gravure du matériau est sensiblement uniforme quelle que soit la direction dans le matériau, notamment une vitesse de gravure dont la valeur varie de moins de 10%, et de préférence de moins de 1%, en fonction de la direction.

En d'autres termes, le caractère isotrope de la gravure, qui attaque donc l'épaisseur de matériau dans toutes les directions, produit une surgravure sous les motifs pleins. Les ilots sont donc fabriqués toujours à l'aide d'une seule étape de gravure, mais en étant surmontés d'« ombrelles » protectrices. Ces ombrelles limitent naturellement les risques de court-circuits ultérieurs lors du dépôt des métallisations, de sorte qu'il n'est donc plus besoin de prendre des mesures ultérieures spécifiques dans ce but, y compris lorsqu'une matrice à très faible pas est fabriquée. Par exemple, il n'est plus besoin de prévoir une couche de passivation. Une très grande simplification de la fabrication des dipôles et de leurs connections est ainsi obtenue. En outre, la métallisation constitutive des connexions du niveau inférieur est déposée directement sur le socle. Non seulement le procédé est encore simplifié, mais en outre il est ainsi obtenu naturellement une électrode sous forme de grille qui entoure les ilots. Cela permet ainsi de prévoir une seule reprise de contact pour l'ensemble des connexions des dipôles prévues sur un niveau inférieur, par exemple les cathodes de photodiodes, en périphérie de la photodiode. La connexion entre deux niveaux est ainsi aisée et peut être réalisée simplement en prévoyant une plage de connexion de hauteur désirée. On note ainsi que le procédé selon l'invention permet un auto-alignement des électrodes lors de la fabrication.

Selon l'invention, la gravure des ilots comprend, préalablement à l'application de la gravure isotrope, une phase pendant laquelle une gravure anisotrope est appliquée. En d'autres termes l'alternance d'une phase anisotrope avec une phase isotrope permet de régler le volume des ilots, et donc de régler le volume de matériau actif des dipôles.

Plus particulièrement, la gravure anisotrope est appliquée de manière à graver l'épaisseur de matériau constitutif des ilots sur une hauteur égale à *h - δ*, où *h* est la hauteur finale des ilots et *δ* est une valeur supérieure ou égale à 0,1 micromètre, et de préférence supérieure ou égale à 0,5 micromètre, et la gravure isotrope est appliquée de manière à graver la hauteur *δ* restante de l'épaisseur de matériau constitutif des ilots. Grâce à ces valeurs, il est possible de fabriquer des matrices de dipôles avec un pas inférieur à 5 micromètres avec un volume d'ilot maximal.

Selon un mode de réalisation, on réalise une passivation des ilots et du socle, ladite passivation étant réalisée uniquement après le dépôt du matériau électriquement conducteur formant les premières et les secondes électrodes. En d'autres termes, une passivation est utilisée, mais uniquement une fois les dipôles avec leur connexions formés. La couche de passivation, avantageusement utilisé pour limiter les recombinaisons en surface des ilots dans le cadre de photodiodes par exemple, n'est plus utilisée pour éviter les court-circuits lors de la fabrication des dipôles. Il existe donc un degré supplémentaire dans le choix de celle-ci.

Selon un mode de réalisation, les ilots sont regroupés dans une zone prédéterminée du socle, et le dépôt du matériau électriquement conducteur pour former les premières et les secondes électrodes consiste en le dépôt d'une couche dudit matériau conducteur sur la totalité du support (i.e. de la surface définie par les ilots et le socle), et donc de ladite zone. Comme précédemment décrit, le dépôt pleine plaque simplifie grandement le procédé et permet de former simplement une électrode sous forme de grille.

Par exemple, le composant auquel est hybridé le composant muni d'ilot selon l'invention dispose d'éléments d'hybridation permettant de rattraper les différences de niveau entre le haut des ilots et le bas des ilots. Notamment, l'hybridation permet de se connecter sur aux électrodes disposés en haut des ilots et en fond de tranchée pour le contact commun, d'une manière par exemple similaire à l'hybridation décrite dans le document « A Novel Blu-free Full-Color LED projector Using LED on Silicon Micro-Displays » de Z.J. Liu et al.

Pour les pas très fins, il est avantageux d'avoir les deux types de connexions (électrodes en haut des ilots et grilles communes en fond de tranchées) au même niveau, à savoir celui défini par les électrodes au sommet des ilots. De préférence, la connexion située en bas des ilots est donc « remontée » au niveau des électrodes disposées aux sommets des ilots.

A cet effet, selon un mode de réalisation de l'invention :
- un motif plein supplémentaire constitué du matériau électriquement conducteur et inerte à ladite gravure est déposé sur l'épaisseur de matériau constitutif des ilots ;
- la gravure est appliquée également au moins partiellement autour du motif plein supplémentaire de manière à former une tranchée jusqu'au socle, la tranchée étant surplombée par le motif plein supplémentaire ;
- préalablement au dépôt du matériau électriquement conducteur en vue de former les premières et les secondes électrodes des dipôles, une gravure locale est appliquée pour éliminer une portion du surplomb au-dessus de la tranchée ; et
- le matériau électrique conducteur est également déposé sur le motif plein supplémentaire et dans la tranchée.

Un ilot supplémentaire, de même hauteur que les ilots formant les dipôles, est ainsi obtenu suite à la gravure. L'élimination d'au moins une portion du surplomb permet par ailleurs de former une connexion électrique entre le motif plein supplémentaire et le fond de la tranchée, et par conséquent avec le socle. L'ilot supplémentaire ainsi métallisé définit alors une borne de connexion pour la grille commune autour des ilots.

Selon un mode de réalisation, le matériau constitutif des ilots est un matériau semi-conducteur et le matériau constitutif des motifs pleins est un métal.

Selon un mode de réalisation, le socle est constitué d'un matériau semi-conducteur ayant un type de conductivité prédéterminé, et les ilots comprennent chacun une portion semi-conductrice ayant un type de conductivité opposée à la conductivité du matériau semi-conducteur du socle de manière à former des diodes avec ledit socle.

### BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :
- la figure 1 est une vue schématique en coupe d'une matrice de photodiodes formée dans un premier composant hybridée avec un second composant comprenant une matrice de polarisation/lecture de la matrice de photodiodes ;
- la figure 2 est une vue schématique en coupe d'une photodiode MESA avec deux électrodes formées au même niveau ;
- les figures 3 à 15 sont des vues schématiques illustrant un procédé de fabrication d'une matrice de dipôles MESA selon l'invention
- les figures 16 et 17 sont des vues schématiques illustrant une variante de fabrication de l'électrode commune pour la reprise de contact de l'électrode en forme de grille formée des MESA ;
- la figure 18 est une vue schématique illustrant la passivation conforme de la matrice de dipôles mise en oeuvre après la réalisation des électrodes ;
- les figures 19 et 20 sont des vues schématiques illustrant une passivation mise en oeuvre après l'hybridation des composants électroniques ; et
- la figure 21 est une vue schématique illustrant un exemple numérique d'une matrice de dipôles fabriquée selon le procédé de l'invention.

### DESCRIPTION DETAILLEE DE L'INVENTION

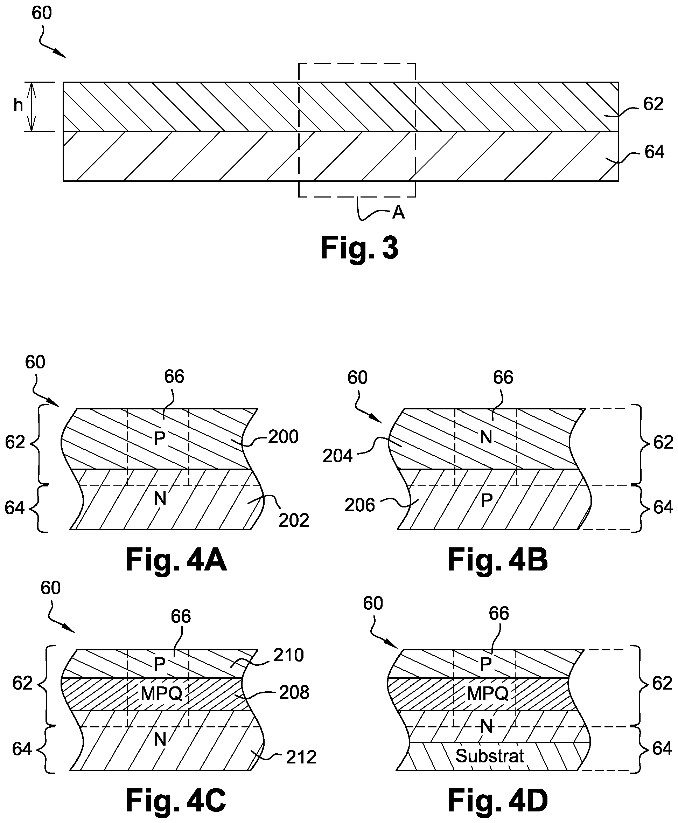

Il va à présent être décrit en relation avec les figures 3 à 15 un premier mode de réalisation du procédé selon l'invention de fabrication collective d'une matrice de dipôles en ilots, la matrice étant destinée à être ultérieurement hybridée avec un circuit externe pour la connexion électrique de chaque dipôle.

Le procédé débute (figure 3) par la réalisation d'une plaque **60** contenant l'ensemble des matériaux actifs constitutifs des dipôles. Cette plaque **60** est divisée entre une première épaisseur **62,** de valeur « *h* », dans laquelle seront formés des ilots et une seconde épaisseur **64** constituant le socle sur lequel reposeront les ilots.

Des plaques **60** utilisées dans le cadre de la fabrication d'une matrice de photodiodes sont illustrées aux figures 4A-4D, qui sont par exemple des vues de détail du cadre **A** de la figure 3.

Par exemple (figure 4A), la plaque **60** comprend une couche **200** de matériau semi-conducteur de type N sur laquelle est déposée une couche **202** de matériau semiconducteur de type P, la fabrication des ilots consistant à individualiser des volumes **66** réalisés dans la totalité de l'épaisseur de la couche **202** et dans une partie de la couche **200.** Sur la figure 4B, l'épaisseur **62** à graver correspond à l'épaisseur d'une couche de matériau semi-conducteur de type N **204** et d'une partie de l'épaisseur d'une couche semi-conductrice de type P **206** déposée sur la couche N **204.** La structure des épaisseurs **62, 64** peut prendre de multiples formes en fonction des photodiodes souhaitées. Par exemple (figure 4C), l'épaisseur **62** comprend un empilement de couches formant des puits quantiques (MPQ) **208,** une couche de matériau semi-conducteur de type P **210** et une partie de l'épaisseur d'une couche de matériau semi-conducteur de type N **212.** De manière analogue (figure 4D), l'épaisseur **64** peut être constituée de différents matériaux, par exemple un substrat en saphir sur lequel est déposée une couche de matériau semi-conducteur de type N. La réalisation de la plaque **60** est classique et ne sera donc pas décrite plus en détail par la suite. Ainsi, les épaisseurs **62, 64** sont illustrées sous la forme de « couches » dans les figures, mais ne correspondent pas nécessairement à des couches de matériau, comme cela est illustré aux figures 4A-4D. Bien évidemment, les épaisseurs **62, 64** peuvent également correspondre à des couches de matériau.

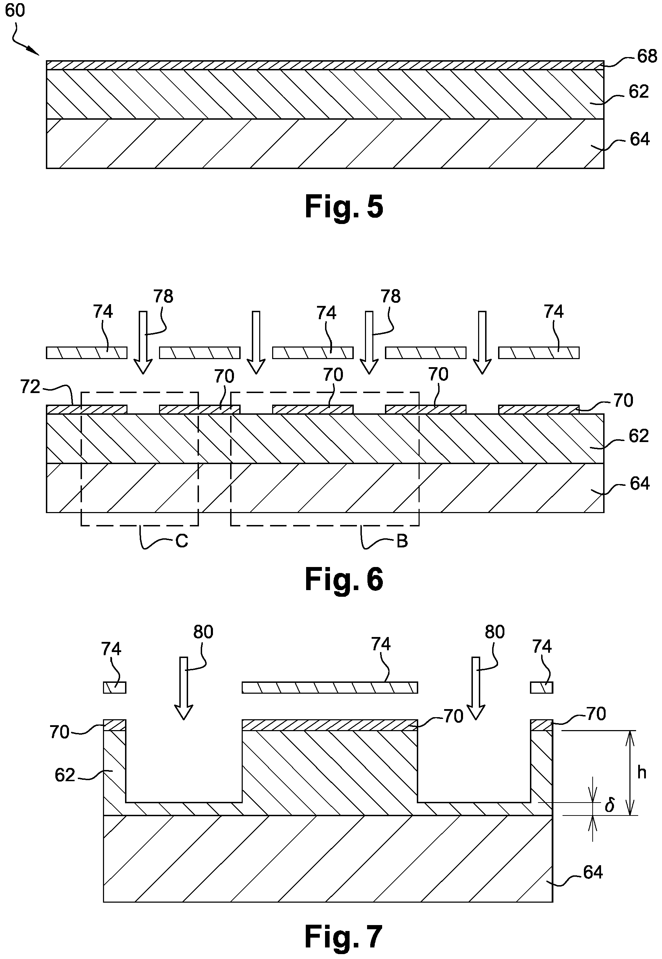

Le procédé se poursuit (figure 5) par le dépôt sur la plaque **60,** au moins sur une portion de celle-ci destinée à la réalisation des ilots, par exemple en totalité sur la plaque **60,** d'une couche **68** de matériau, qui est à la fois conducteur électrique et inerte au moins à une gravure ultérieurement appliquée pour individualiser les ilots. Avantageusement la vitesse de gravure du matériau de la couche **68** est inférieure ou égale à 1/10^{e}, et de préférence inférieure ou égale à 1/100^{e}, notamment inférieure ou égale à 1/1000^{e}, de la vitesse de gravure du matériau de l'épaisseur **62.** L'épaisseur de la couche **68** est avantageusement supérieure ou égale à 10 nm afin de limiter le risque d'effondrement de surplombs réalisés ultérieurement sous le poids d'un matériau conducteur ultérieurement déposé comme détaillé ci-après.

Des motifs pleins **70** sont ensuite réalisés à partir de la couche **68** aux emplacements souhaités pour les ilots, la géométrie des motifs **70** étant choisie en fonction de la géométrie souhaitée pour les ilots (rectangulaire, carré, circulaire, etc.). Un motif supplémentaire **72** est également réalisé en périphérie de la matrice de motifs **70** à des fins de connexion électrique comme cela sera expliqué ci-après. Les motifs **70, 72** sont par exemple obtenus en superposant un masque de gravure **74** à la couche **68** et en appliquant une gravure sèche anisotrope, notamment à base de plasma ou ionique, d'une manière connue en soi. Bien entendu, les motifs pleins **70, 72** peuvent être obtenus différemment, par exemple par l'emploi d'une photolithographie à base de photorésine et de dépôt chimique en phase vapeur.

Dans une étape suivante du procédé, une gravure est appliquée autour de motifs pleins **70, 72,** qui servent ainsi de masque, pour réaliser des tranchées dans l'épaisseur **62** jusqu'à l'épaisseur **64,** et ainsi individualiser des ilots entrant dans la constitution des dipôles. Plus particulièrement, comme cela est illustré à la figure 7, qui est une vue de détail du cadre B de la figure 6, une première gravure anisotrope **80** est tout d'abord appliquée afin de graver une épaisseur *h - δ* de l'épaisseur **62.** Cette gravure **80** est donc calibrée pour obtenir une très forte sélectivité d'attaque telle que le ratio de la vitesse d'attaque du matériau de la couche **62** sur la vitesse d'attaque du matériau des motifs **70, 72** soit supérieure à 10, de préférence supérieure à 100, de préférence supérieure à 1000.

A la fin de la gravure **80,** il subsiste donc dans les tranchées ainsi formées une portion résiduelle *δ* de l'épaisseur **62.**

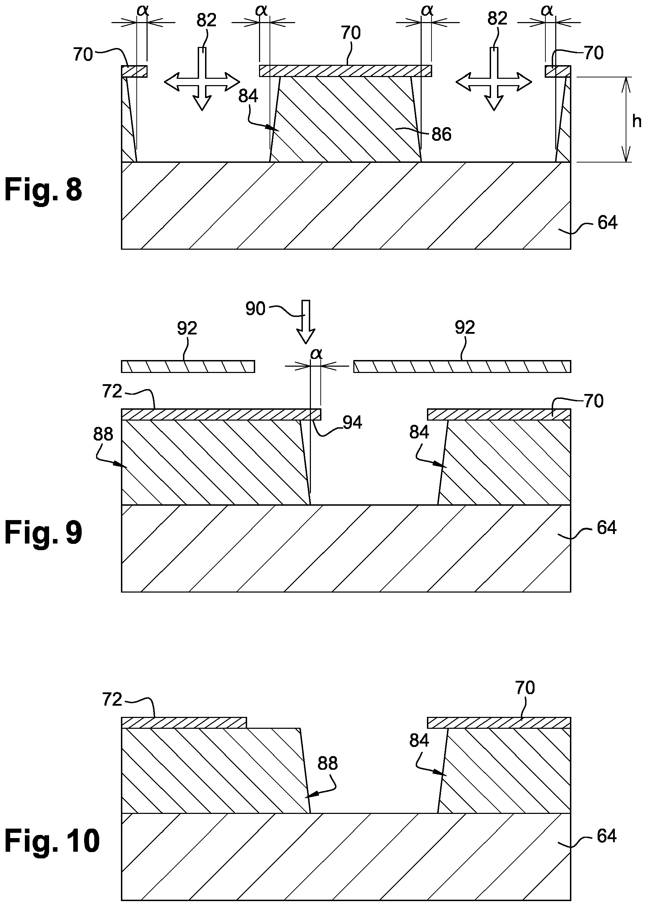

Une deuxième gravure isotrope **82** (figure 8) est ensuite appliquée pour retirer la portion restante *δ* de l'épaisseur **62** restante dans les tranchées. Comme cette deuxième gravure est isotrope, elle grave donc également le matériau sous les motifs pleins **70** en formant des flancs d'ilots inclinés. Plus particulièrement, l'épaisseur restante *δ* est choisie de sorte que son retrait par la gravure isotrope choisie ait pour conséquence une surgravure telle que les motifs pleins **70, 72** surplombent totalement les ilots **84, 88,** les motifs pleins **70, 72** dépassant le pied des ilots d'une largeur *α* mesurée dans le plan de l'épaisseur **64.** Par exemple, dans le cadre d'ilots tronconiques, les pieds des ilots **84** sont des disques de rayon *R* et les motifs **70** sont des disques de rayon *R* + *α*, ou dans le cadre d'ilots à section carrée, les pieds des ilots **84** sont des carrées de côté *R* et les motifs **70** sont des carrés de côté *R* + *α*.

De manière avantageuse, les deux gravures anisotrope et isotrope sont mises en oeuvre en série dans une même machine, ce qui évite ainsi d'avoir à manipuler la plaque. Notamment, une gravure RIE est utilisé. Comme cela est connu, cette gravure combine deux types de réaction entre un plasma et le matériau à graver. Une première réaction physique du plasma avec le matériau, dite « ionique », est très directive et donc anisotrope. Une seconde réaction chimique du plasma avec le matériau, dite « chimique », est très peu directive et donc isotrope. Par ailleurs, avec ce type de gravure, il est possible de pondérer chacune des réactions en fonction du taux d'isotropie/anisotropie souhaité pour la gravure, ce qui est l'un des avantages bien connu de ce type de gravure.

Selon l'invention, la gravure est donc contrôlée :
- selon une première phase pendant laquelle le processus ionique est favorisé de manière à graver la portion *h - δ* de l'épaisseur **62 ;**
- puis selon une deuxième phase selon laquelle le processus chimique est favorisé de manière à graver la portion restante *δ* de l'épaisseur **62.**

En se référant à la vue de détail de la figure 9, correspondant au cadre C de la figure 6, la gravure décrite précédemment a également formé un ilot **88,** de même hauteur que les ilots **84,** surplombé du motif plein périphérique **72.**

Le procédé se poursuit par l'application d'une gravure sur une zone spécifique du composant où il est souhaité réaliser une remontée de l'électrode commune réalisée ultérieurement au fonds des tranchées, par une gravure RIE **90** réalisée au travers d'un masque **92,** de manière à éliminer partiellement ou en totalité la partie **94** du motif **72** qui fait saillie de l'ilot **88,** comme illustré à la figure 10.

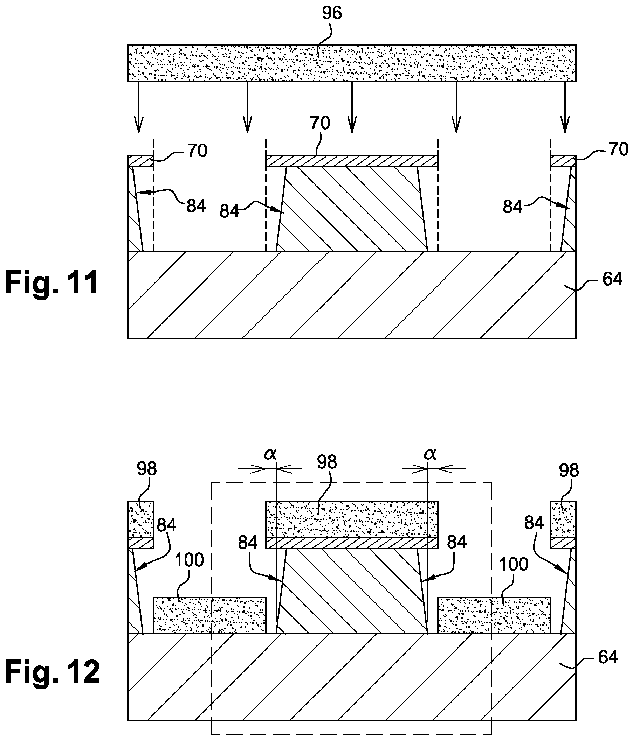

Un dépôt de matériau conducteur **96** est ensuite mis en oeuvre (figure 11) sur toute la surface de l'ensemble obtenu (ou dépôt « pleine plaque »), et par conséquent sur et autour des ilots **84** et de l'ilot **88.** Par exemple, un dépôt en phase vapeur est utilisé. Ainsi, le surplomb *α* des motifs pleins **70** joue alors le rôle de masque en protégeant les flancs des ilots **84** (figure 12). Il est donc obtenu une première électrode **98** au sommet de chaque ilot **84,** ici constituée du motif plein **70** et d'une couche du matériau conducteur **96,** et une deuxième électrode commune **100** en forme de grille constituée d'une couche du matériau conducteur **96** et disposée au pied des ilots **84,** sans qu'il y ait de court-circuit électrique entre la première et la deuxième électrode **98, 100.**

Par ailleurs, les électrodes **98, 100** sont « automatiquement » alignées avec les ilots **84.** Il est ainsi obtenu une matrice de dipôles, chacun formé d'un ilot surmonté d'une première électrode et d'une deuxième électrode disposée à son pied. En outre, le surplomb *α* est choisie minimal, c'est-à-dire juste suffisante pour obtenir l'effet de masque recherché. Ainsi, le volume **84,** qui est le volume de matériau actif des dipôles, par exemple le matériau intervenant dans la jonction PN d'une photodiode, est maximal.

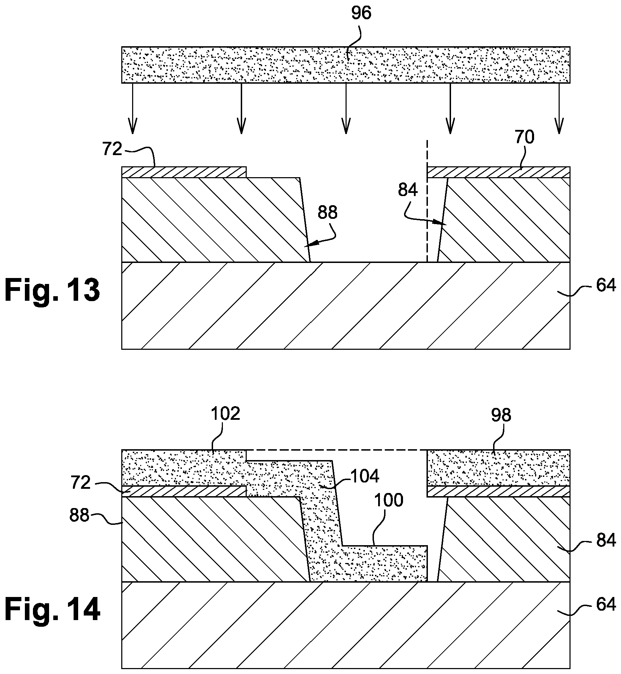

Parallèlement, en se référant aux vues de détail des figures 13 et 14, en raison de l'absence de surplomb sur l'ilot périphérique **88** et l'inclinaison des flancs de l'ilots **88,** le dépôt du matériau conducteur **98** (figure 13) a pour effet de former une électrode **102** sur le sommet de l'ilot **88** qui se prolonge par une portion **104** sur le flanc de l'ilot **88** et par la deuxième électrode commune **100** des dipôles (figure 14). Notamment, l'électrode **102** est au même niveau que les premières électrodes **98** des dipôles.

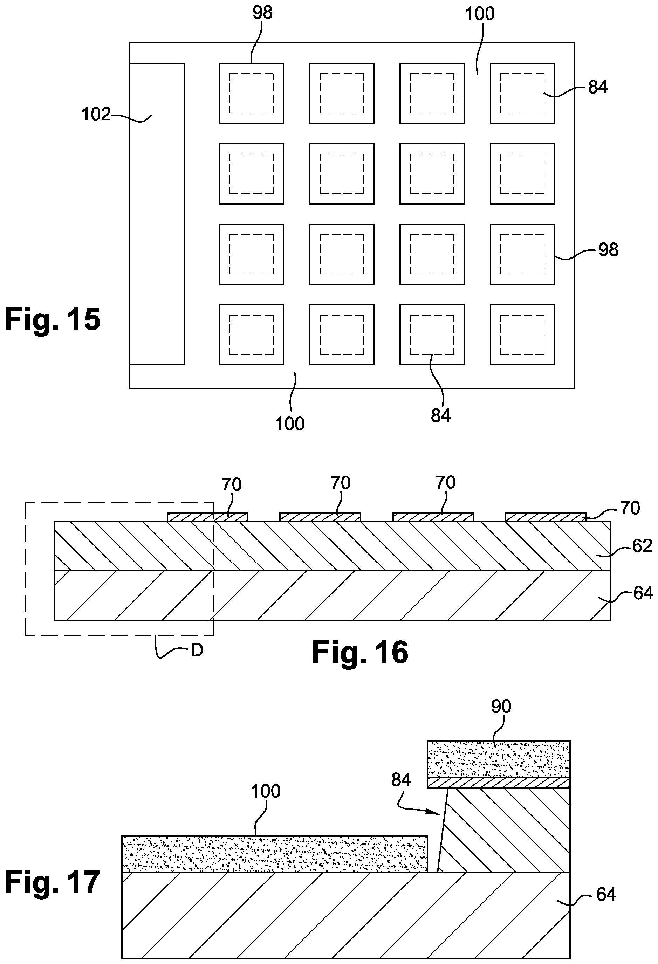

En se référant à la vue de dessus de la figure 15 du composant électronique ainsi obtenu, avec des motifs pleins **70** carrés et le motif plein supplémentaire **72** rectangulaire, on note ainsi que la deuxième électrode **100** forme une grille autour des ilots qui est en continuité électrique avec l'électrode périphérique **102.** Les dipôles sont ainsi pilotés individuellement via leurs premières électrodes **98,** alors que la deuxième électrode **100** permet de porter au même potentiel, par exemple le commun du circuit. En outre pour l'hybridation, les premières électrodes **98** et l'électrode périphérique **102** sont au même niveau. Il n'est donc pas besoin de prévoir des éléments d'interconnexion de hauteurs différentes pour l'hybridation.

Bien qu'avantageuse, la mise à niveau des connexions est optionnelle. En se référant aux figures 16 et 17, une variante de fabrication diffère du procédé décrit ci-dessus en ce que le motif plein supplémentaire **72** est omis (figure 16), et en ce qu'il n'existe donc pas d'étape de gravure telle que décrite aux figures 9 et 10. Le dépôt du matériau conducteur **96** mène ainsi à une électrode **100,** qui se prolonge en périphérie du composant électronique ainsi réalisé (vue de détail de la figure 17 correspondant au cadre D). Soit il est prévu un élément d'interconnexion de hauteur supérieure pour la connexion de l'électrode **100,** soit un motif conducteur rattrapant la différence de niveau est déposé sur l'électrode **100.**

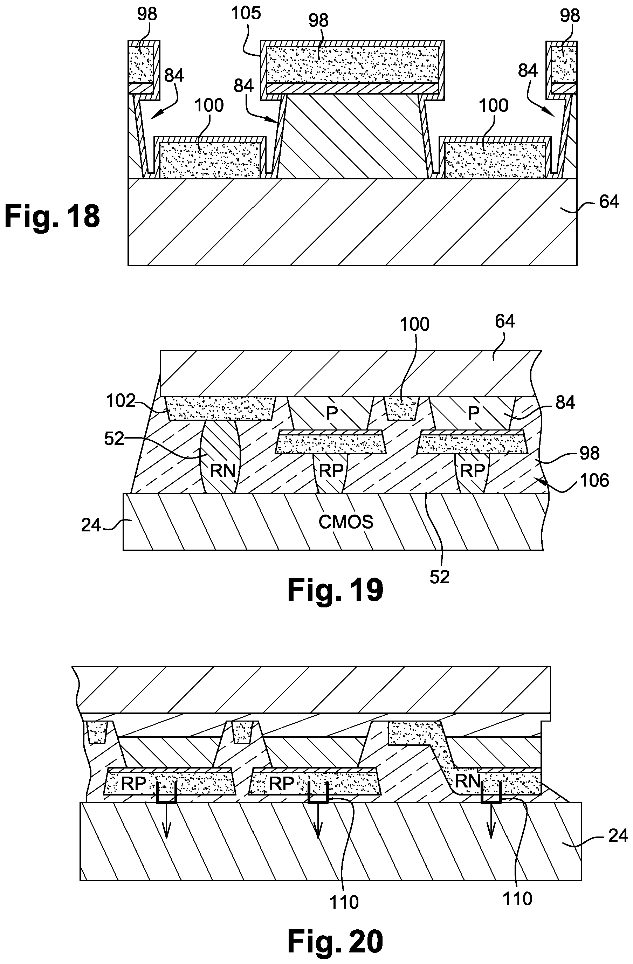

Il peut être noté qu'à ce stade, aucune passivation des dipôles n'a encore été réalisée. Avantageusement, la passivation intervient uniquement une fois les dipôles et leurs électrodes fabriquées. Plus particulièrement, en se référant à la figure 18, une couche de passivation **105** est déposée pleine plaque au moyen d'une technique de dépôt isotrope conforme, par exemple un dépôt chimique en phase vapeur, notamment un dépôt de couche atomique (« *atomic layer deposition* ») d'Al₂O₃, afin d'obtenir une couche de passivation qui recouvre toutes les surfaces des dipôles, et donc leurs flancs. La couche de passivation **105** recouvre donc également les électrodes **98, 100** des dipôles. De manière avantageuse, l'hybridation utilise alors un insert creux, qui vient s'insérer en force dans chaque électrode **98** et l'électrode périphérique **102** en brisant la couche de passivation **105.**

En variante, la couche de passivation **105** est omise et la passivation est mise en oeuvre uniquement une fois l'hybridation réalisée en introduisant entre les deux composants hybridés un matériau de remplissage **106** ayant une propriété passivante et présentant une forte résistivité électrique (communément appelé « *underfill* »). Par exemple, l'underfill remplit l'espace entre les composants hybridés à l'aide de billes de soudure **52** (figure 19) ou à l'aide d'inserts creux **110** insérés respectivement dans les électrodes **98, 102** (figure 20). Par exemple, l'underfill est une résine époxy à faible viscosité tel que de l'Epotek© 353 ND ou l'EPOTEK 301 et ayant une résistivité électrique volumique supérieure à 1,8.10¹¹ ohm. cm après réticulation.

Comme décrit précédemment, le matériau des motifs pleins **70** et **72** est choisi à la fois pour être conducteur et pour être inerte au moins à la phase isotrope de la gravure de formation des ilots, et de préférence inerte à la totalité de la gravure.

Notamment, pour une épaisseur **62** à graver, constituée de matériau semi-conducteur GaN, InGaN, InGaAs, CdHgTe, InP, SnPb, Ge, Si.... et, plus généralement, tous les matériaux et empilements traditionnels permettant de réaliser des circuits de détection ou d'émission « OPTIQUES » , construits à partir d'alliages ou d'empilements de matériaux issus des colonnes II à VI (semiconducteurs des Groupes III-V et groupe II-VI) et pour une gravure isotrope chimique humide, gazeuse ou physique ou le couplage des trois plasma, le matériau **68** des motifs pleins **70, 72** est choisi en métal, notamment choisi parmi Ag, Al, Ni, Pt, Ni, Ti et alliages de Ti (TiN, TiW,...), Pd, Au, W et alliages de W (WSi, WN,...) et Co, et de préférence du Ni ou du Pt.

Le matériau **68** peut également être un multicouches de ces métaux et alliages. En outre, ces matériaux sont également inertes à une gravure anisotrope adaptée.

Le matériau **68** des motifs peut également être choisi en fonction de l'hybridation mise en oeuvre. Par exemple, l'or, le platine et le nickel sont privilégiés lorsque les électrodes **98, 102** sont réalisées en matériau dit de « soudure », par exemple de l'indium, un alliage d'indium, de l'étain ou un alliage d'étain, matériau qui sont traditionnellement utilisés dans le cas d'assemblage de type flip-chip

Par exemple, le titane et les alliages de titane sont privilégiés si les électrodes **98, 102** sont réalisés en aluminium car ils permettent une bonne adhérence du dépôt final d'aluminium et sont utilisés généralement dans ce but comme « couche d'accroche » de l'aluminium avant dépôt en raison de leur bonne affinité avec l'aluminium.

En outre, le matériau **68** des motifs **70, 72** peut également être choisi en fonction de l'application visée par la matrice de dipôles. Par exemple, certains afficheurs à base de photodiodes sont conçus pour émettre de la lumière par leur face arrière, c'est-à-dire au travers de l'épaisseur **64** qui est choisie transparente à la longueur d'onde visible d'émission des photodiodes. Le matériau **68** des motifs **70** est ainsi choisi pour présenter un fort pouvoir réflecteur à cette longueur d'onde. Par exemple, le matériau est l'argent.

Evidemment, le matériau **96** des électrodes **98, 100, 102** peut également être identique au matériau **68** des motifs pleins **70, 72.**

Concernant la largeur *α* du surplomb entre le pied des ilots **84** et les motifs pleins **70,** les inventeurs ont noté qu'une largeur supérieure à 0,1 micromètre, et notamment supérieure à 0,5 micromètre, permet de protéger de manière efficace les flancs des ilots lors du dépôt des électrodes **98, 100.** En outre, au-delà de 1 micromètre, il n'est observé aucun gain particulier en termes de protection.

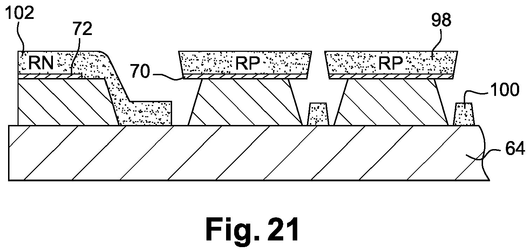

La figure 21 illustre un exemple numérique d'une matrice de photodiodes fabriquée selon le procédé décrit précédemment. La couche à graver est une couche telle que décrite à la figure 4C et réalisée par croissance épitaxiale des couches la constituant, d'une épaisseur de 1000 nanomètres. Les motifs **70** sont des carrés de côté égal à 2300 nanomètres et d'une épaisseur de 100 nanomètres, cette épaisseur étant donc également celle du motif périphérique **72,** la distance séparant les motifs **70** étant égale à 700 nanomètres. Le matériau des motifs **70, 72** est du nickel ou de l'or et le métal des électrodes **98, 100, 102** est un matériau de soudure en vue d'une hybridation par insertion, comme décrit ci-dessous, d'une épaisseur de 500 nanomètres. Le surplomb *α* est égal à 300 nanomètres. La matrice de photodiodes ainsi obtenue présente donc un pas de 3000 nanomètres, c'est-à-dire un pas faible (inférieur à 5 micromètres) relativement aux pas de matrices de photodiodes de l'état de la technique supérieur à 10 micromètres.

Il a été décrit des modes de réalisation particuliers, notamment concernant la gravure appliquée. Bien entendu tout type de gravure permettant de former un surplomb protégeant les flancs et les pieds des ilots lors d'un dépôt ultérieur de matériau convient. Par exemple, il est possible d'alterner plusieurs phases de gravures anisotropes avec plusieurs phases de gravure isotrope dans des enchainements dédiés pour obtenir des profils de gravure spécifiques et contrôler plus finement la forme du surplomb α.

De même, il est possible d'appliquer uniquement une gravure isotrope pour individualiser les ilots en réglant les paramètres de gravure pour réaliser une isotropie contrôlée de manière à obtenir le surplomb souhaité, par exemple en contrôlant le facteur d'isotropie I = α/h.

De même, il est possible d'utiliser des gravures différentes, par exemple une gravure RIE pour la phase anisotrope et une gravure chimique humide (« *wet chemical etching* ») pour la phase isotrope.

Il a été décrit une application à la réalisation d'une matrice de photodiodes de type MESA. Bien entendu, l'invention s'applique à la fabrication de tout type de dipôle de type MESA nécessitant la connexion à deux niveaux. Par exemple, la problématique exposée ci-dessus s'applique à une matrice de photoconducteurs, par exemple formés d'un empilement N/N+ ou P/P+, à une matrice de capacités, une matrice de bolomètres, une matrice de diode Zener, etc.

L'invention présente au moins les avantages suivants :
- la fabrication de dispositifs optiques « hybridables » (puces d'émission ou de détection) à petit pas, et de grande taille (matrice tricolores, projecteurs, µdisplay, IR, visible, X, visibles, matrice d'émetteur VCSEL...) ;
- la possibilité d'utiliser les techniques de fiabilisation de l'état de la technique. Ainsi, le dispositif final assemblé peut être fiabilisé par enrobage ou dépôt de passivation conforme ;
- une reprise de contact aisée du plot commun, notamment en ayant un même niveau de connexion.

## Revendications

1. Procédé de fabrication d'un composant électronique (10) comportant une pluralité de dipôles (70, 98, 84, 100), chacun comportant un ilot (84) solidaire d'un socle (64), une première électrode (98) disposée au sommet de l'ilot (84) et une seconde électrode (100) disposée sur le socle (64), le procédé comportant :
- la réalisation, sur le socle (64), d'une épaisseur de matériau constitutif des ilots (62), ladite épaisseur (62) étant apte à être gravée à l'aide d'une gravure isotrope prédéterminée;
- suivie de la réalisation, sur l'épaisseur de matériau constitutif des ilots (62), de motifs pleins (70) en matériau électriquement conducteur et inerte à la gravure isotrope;
- suivie de l'application d'une gravure de l'épaisseur de matériau constitutif des ilots (62) jusqu'au socle (64) au moins entre lesdits motifs pleins (70) de manière à former des ilots (84) surmontés desdits motifs pleins (70), ladite gravure comportant au moins une phase pendant laquelle la gravure isotrope prédéterminée est appliquée de manière à ce que les motifs pleins (70) surplombent totalement les ilots (84); et
- suivie du dépôt de matériau électriquement conducteur (96) sur et entre les ilots (84) de manière à former les premières et les secondes électrodes (98, 100) des dipôles.

2. Procédé de fabrication d'un composant électronique selon la revendication 1, dans lequel la gravure des ilots (84) comprend, préalablement à l'application de la gravure isotrope, une phase pendant laquelle une gravure anisotrope est appliquée.

3. Procédé de fabrication d'un composant électronique selon la revendication 2, dans lequel :
- la gravure anisotrope est appliquée de manière à graver l'épaisseur de matériau constitutif des ilots (62) sur une hauteur égale à *h - δ*, où *h* est la hauteur finale des ilots (84) et *δ* est une valeur supérieure ou égale à 0,1 micromètre, et de préférence supérieure ou égale à 0,5 micromètre ; et
- la gravure isotrope est appliquée de manière à graver la hauteur *δ* restante de l'épaisseur de matériau constitutif des ilots (62).

4. Procédé de fabrication d'un composant électronique selon l'une quelconque des revendications précédentes, comprenant une passivation des ilots (84) et du socle (64), ladite passivation étant réalisée uniquement après le dépôt du matériau électriquement conducteur (96) formant les premières et les secondes électrodes (98, 100).

5. Procédé de fabrication d'un composant électronique selon l'une quelconque des revendications précédentes, dans lequel le dépôt du matériau électriquement conducteur (96) pour former les premières et les secondes électrodes (98, 100) consiste en le dépôt d'une couche dudit matériau conducteur sur la totalité de la surface constituée des ilots (84) et du socle (64).

6. Procédé de fabrication d'un composant électronique selon l'une quelconque des revendications précédentes, dans lequel :
- un motif plein supplémentaire (72) constitué du matériau électriquement conducteur et inerte à ladite gravure est déposé sur l'épaisseur de matériau constitutif des ilots (62);
- la gravure est appliquée également au moins partiellement autour du motif plein supplémentaire (72) de manière à former une tranchée jusqu'au socle (64), la tranchée étant surplombée par le motif plein supplémentaire (72) ;
- préalablement au dépôt du matériau électriquement conducteur (96) en vue de former les premières et les secondes électrodes (98, 100) des dipôles, une gravure locale est appliquée pour éliminer au moins une portion du surplomb au-dessus de la tranchée ; et
- le matériau électrique conducteur (96) est également déposé sur le motif plein supplémentaire (72) et dans la tranchée.

7. Procédé de fabrication d'un composant électronique selon l'une quelconque des revendications précédentes, dans lequel le matériau constitutif des ilots (84) est un matériau semi-conducteur, et le matériau constitutif des motifs pleins (70) est un métal.

8. Procédé de fabrication d'un composant électronique selon l'une quelconque des revendications précédentes, dans lequel le socle (64) est constitué d'un matériau semi-conducteur ayant un type de conductivité prédéterminé, et dans lequel les ilots (84) comprennent chacun une portion semi-conductrice ayant un type de conductivité opposée à la conductivité du matériau semi-conducteur du socle (64) de manière à former des diodes avec ledit socle (64).

## Patentansprüche

1. Verfahren zur Herstellung eines elektronischen Bauteils (10), das eine Vielzahl von Dipolen (70, 98, 84, 100) umfasst, von denen jeder eine Insel (84) umfasst, die fest mit einer Basis (64) verbunden ist, sowie eine erste Elektrode (98), die am Gipfel der Insel (84) angeordnet ist und eine zweite Elektrode (100), die an der Basis (64) angeordnet ist, wobei das Verfahren umfasst:
- Ausführung einer Materialschicht, auf der Basis (64), die die Inseln (62) bildet, wobei diese Schicht (62) mit einem vorher bestimmten isotropen Ätzmittel geätzt werden kann;
- darauf folgt die Ausführung, auf der Materialschicht, die die Inseln (62) bildet, von ausgefüllten Mustern (70) aus elektrisch leitendem und gegenüber dem isotropen Ätzmittel inerten Material;
- gefolgt vom Auftragen eines Ätzmittels auf der Materialschicht, die die Inseln (62) bildet bis zur Basis (64), zumindest zwischen den genannten ausgefüllten Mustern (70), so dass Inseln (84) überragt von diesen ausgefüllten Mustern (70) gebildet werden, wobei dieses Ätzmittel mindestens eine Phase umfasst, in der das vorher bestimmte isotrope Ätzmittel in einer Art und Weise aufgetragen wird, dass die ausgefüllten Muster (70) die Inseln (84) vollständig überragen; und
- gefolgt von der Ablagerung des elektrisch leitenden Materials (96) auf und zwischen den Inseln (84), so dass die ersten und zweiten Elektroden (98, 100) der Dipole gebildet werden.

2. Verfahren zur Herstellung eines elektronischen Bauteils gemäß Anspruch 1, bei dem das Ätzen der Inseln (84) vor dem Auftragen des isotropen Ätzmittels eine Phase umfasst, in der ein anisotropes Ätzmittel aufgetragen wird.

3. Verfahren zur Herstellung eines elektronischen Bauteils gemäß Anspruch 2, bei dem:
- das anisotrope Ätzmittel so aufgetragen wird, dass die Materialschicht, die die Inseln (62) bildet, auf einer Höhe gleich *h - δ*, geätzt wird, wobei *h* die endgültige Höhe der Inseln (84) ist und *δ* ein Wert größer oder gleich 0,1 Mikrometer, am bestem über oder gleich 0,5 Mikrometer, ist; und
- das isotrope Ätzmittel so aufgetragen wird, dass die verbleibende Höhe *δ* der Materialschicht, die die Inseln (62) bildet, geätzt wird.

4. Verfahren zur Herstellung eines elektronischen Bauteils gemäß einem der vorstehenden Ansprüche, umfassend eine Passivierung der Inseln (84) und der Basis (64), wobei diese Passivierung erst nach der Ablagerung des elektrisch leitenden Materials (96), dass die ersten und zweiten Elektroden (98, 100) bildet, aufgetragen wird.

5. Verfahren zur Herstellung eines elektronischen Bauteils gemäß einem der vorstehenden Ansprüche, bei dem die Ablagerung des elektrisch leitenden Materials (96) zur Bildung der ersten und zweiten Elektroden (98, 100) in der Ablagerung einer Schicht dieses leitenden Materials auf der gesamten Oberfläche, gebildet von Inseln (84) und Basis (64) besteht.

6. Verfahren zur Herstellung eines elektronischen Bauteils nach einem der vorstehenden Ansprüche, bei dem:
- ein zusätzliches ausgefülltes Muster (72), bestehend aus dem elektrisch leitenden und gegenüber diesem Ätzmittel inerten Material auf dieser Materialschicht, die die Inseln (62) bildet, abgelagert wird;
- das Ätzmittel auch zumindest teilweise um das ausgefüllte Muster (72) herum aufgetragen wird, so dass ein Graben bis zur Basis (64) gebildet wird, wobei der Graben von dem zusätzlichen ausgefüllten Muster (72) überragt wird;
- vor der Ablagerung des elektrisch leitenden Materials (96) zur Bildung der ersten und zweiten Elektroden (98, 100) der Dipole, ein lokales Ätzmittel aufgetragen wird, um zumindest einen Teil der Auskragung über dem Graben zu entfernen; und
- das elektrisch leitende Material (96) auch auf dem zusätzlichen ausgefüllten Muster (72) und im Graben aufgetragen wird.

7. Verfahren zur Herstellung eines elektronischen Bauteils nach einem der vorstehenden Ansprüche, bei dem das Material, das die Inseln (84) bildet, ein Halbleiter ist, und das Material, das die ausgefüllten Muster (70) bildet, ein Metall ist.

8. Verfahren zur Herstellung eines elektronischen Bauteils nach einem der vorstehenden Ansprüche, bei dem die Basis (64) aus einem Halbleitermaterial besteht, dass eine vorher bestimmte Konduktivität aufweist und bei dem die Inseln (84) jeweils einen Halbleiter-Abschnitt enthalten, dessen Konduktivitätstyp zur Konduktivität des Halbleitermaterials der Basis (64) entgegengesetzt ist, so dass sie Dioden mit dieser Basis (64) bilden.

## Claims

1. A method of manufacturing an electronic component (10) comprising a plurality of dipoles (70, 98, 84, 100), each comprising an island (84) solid with a base (64), a first electrode (98) arranged at the top of the island (84) and a second electrode (100) arranged on the base (64), the method comprising
- forming, on the base (64), a thickness of a material forming the islands (62), said thickness (62) being etchable by means of a predetermined isotropic etching;
- then, forming, over the thickness of material forming the islands (62), solid patterns (70) made of electrically-conductive material and inert to isotropic etching;
- then, applying an etching on the thickness of the material forming the islands (62) all the way to the base (64) at least between said solid patterns (70) to form islands (84) topped with said solid patterns (70), said etching comprising at least one phase during which the predetermined isotropic etching is applied so that the solid patterns (70) totally overhang the islands (84); and
- then, depositing electrically conductive material (96) on top of and between the islands (84) to form the first and second electrodes (98, 100) of the dipoles.

2. The electronic component manufacturing method of claim 1, wherein the etching of the islands (84) comprises, prior to the application of the isotropic etching, a phase during which an anisotropic etching is applied.

3. The electronic component manufacturing method of claim 2, wherein:
- the anisotropic etching is applied to etch the thickness of material forming the islands (62) along a height equal to *h - δ* where *h* is the final height of the islands (84) and *δ* is a value greater than or equal to 0.1 micrometer, and preferably greater than or equal to 0.5 micrometer; and
- the isotropic etching is applied to etch the remaining height *δ* of the thickness of material forming the islands (62).

4. The electronic component manufacturing method of any of the foregoing claims, comprising a passivation of the islands (84) and of the base (64), said passivation being performed only after the deposition of the electrically-conductive material (96) forming the first and the second electrodes (98, 100).

5. The electronic component manufacturing method of any of the foregoing claims, wherein the deposition of the electrically-conductive material (96) to form the first and second electrodes (98, 100) comprises depositing a layer of said conductive material all over the surface defined by the islands (84) and the base (64).

6. The electronic component manufacturing method of any of the foregoing claims, wherein:
- an additional solid pattern (72) made of the electrically-conductive material and inert to said etching is deposited over the thickness of material forming the islands (62);
- the etching is also at least partially applied around the additional solid pattern (72) to form a trench all the way to the base (64), the trench being overlooked by the additional solid pattern (72);
- prior to the deposition of the electrically conductive material (96) to form the first and the second electrodes (98, 100) of the dipoles, a local etching is applied to remove at least a portion of the overhang above the trench; and
- the electric conductor material (96) is also deposited on the additional solid pattern (72) and in the trench.

7. The electronic component manufacturing method of any of the foregoing claims, wherein the material forming the islands (84) is a semiconductor material and the material forming the solid patterns (70) is a metal.

8. The electronic component manufacturing method of any of the foregoing claims, wherein the base (64) is made of a semiconductor material having a predetermined conductivity type, and wherein the islands (84) each comprise a semiconductor portion having a conductivity type opposite to the conductivity of the semiconductor material of the base (64) to form diodes with said base (64).
